Europäisches Patentamt

European Patent Office

Office européen des brevets

(19)

(11) Numéro de publication : **0 160 594**
**B1**

(12) **FASCICULE DE BREVET EUROPÉEN**

(45) Date de publication du fascicule du brevet :
04.05.88

(51) Int. Cl.⁴ : **H 03 H   9/05**

(21) Numéro de dépôt : **85400587.3**

(22) Date de dépôt : **26.03.85**

(54) **Résonateur piézo-électrique.**

(30) Priorité : **30.03.84 FR 8405036**

(43) Date de publication de la demande :
**06.11.85 Bulletin 85/45**

(45) Mention de la délivrance du brevet :
**04.05.88 Bulletin 88/18**

(84) Etats contractants désignés :
**BE CH DE GB LI NL**

(56) Documents cités :
**EP-A- 0 070 503**
**DE-A- 2 840 162**
**FR-A- 2 136 643**
**FR-A- 2 415 914**
**US-A- 4 266 157**

(73) Titulaire : **COMPAGNIE D'ELECTRONIQUE ET DE PIE-**
**ZO-ELECTRICITE - C.E.P.E.**
**44, rue de la Glacière**
**F-95100 Argenteuil (FR)**

(72) Inventeur : **Aubry, Jean-Pierre**
**THOMSON-CSF SCPI 173, bld. Haussmann**
**F-75379 Paris Cedex 08 (FR)**
Inventeur : **Debaisieux, André**
**THOMSON-CSF SCPI 173, bld. Haussmann**
**F-75379 Paris Cedex 08 (FR)**

(74) Mandataire : **Ruellan-Lemonnier, Brigitte et al**
**THOMSON-CSF SCPI 19, avenue de Messine**
**F-75008 Paris (FR)**

EP 0 160 594 B1

Jouve, 18, rue St-Denis, 75001 Paris, France

## Description

La présente invention concerne un résonateur piézo-électrique du type décrit dans le brevet français FR-A-2 415 914. Ce résonateur comporte une embase traversée par deux poteaux conducteurs électriquement isolés de celle-ci et une lame piézo-électrique comportant une zone active centrale entourée par une couronne périphérique reliée à la zone centrale par au moins deux ponts délimitant des fentes séparant la zone centrale de la couronne périphérique, chaque face de la zone centrale étant revêtue d'une électrode adhérente se prolongeant au travers de l'un au moins des ponts sur une partie de la couronne périphérique, chaque électrode de la lame étant reliée à l'un des poteaux conducteurs par l'intermédiaire de moyens de fixation conducteurs.

Des résonateurs de ce type ont aussi été décrits dans les demandes françaises 83/15 652 intitulée « RESONATEUR AUTO-SUSPENDU DE HAUTE SURTENSION », 83/15 653 intitulée « RESONATEUR DE FAIBLE SENSIBILITE AUX ACCELERA-TIONS » et 83/15 654 intitulée « RESONATEUR PIEZO-ELECTRIQUE POUR ENVIRONNEMENT SEVERE », demandes déposées conjointement par la Demanderesse le 30 septembre 1983 et correspondant respectivement aux demandes de Brevets Européens EP-A-0 136 942 (publiée 10.04.85) EP-A-0 136 943 (publiée 10.04.85) et EP-A-0 143 680 (publiée 05.06.85) .

Ces différents résonateurs piézo-électriques sont maintenus solidaires de l'embase par des poteaux conducteurs traversant ladite embase et reliés électriquement aux électrodes de la lame piézo-électrique sur le bord externe de la couronne périphérique desdites lames. Toutefois, en pratique, afin de diminuer les coûts de production, on utilise généralement des embases couramment disponibles dans le commerce quelles que soient les dimensions des lames piézo-électriques fixées à l'intérieur du boîtier. On constate généralement que le diamètre de ces lames piézo-électriques est différent et dans la plupart des cas, supérieur au diamètre sur lequel sont disposés les poteaux de l'embase. Il en résulte que les moyens de fixation des poteaux à la lame de quartz sont réalisés à l'aide de fils ou rubans métalliques inclinés par rapport à la direction desdits poteaux. On constate généralement, que les performances des résonateurs utilisant les modes de fixation décrits ci-dessus, sont assez médiocres en ce qui concerne la sensibilité aux accélérations. D'une manière générale, pour une lame de quartz traditionnelle, c'est-à-dire non munie de fentes comme dans le cas de la présente invention, la sensibilité aux accélérations des résonateurs ainsi obtenus n'est pas inférieure à $1 \times 10^{-9}/G$. De plus, une telle valeur de la sensibilité aux accélérations n'est pas aisément reproductible d'un résonateur à l'autre. Lorsqu'on utilise des lames piézo-électriques munies de fentes selon la demande française 83/15 653 (EP-A-0 136 943) citée plus haut, on améliore nettement cette sensibilité aux accélérations puisque l'on obtient une sensibilité inférieure à $1 \times 10^{-9}/G$. Mais comme dans le cas précédent et bien que les résultats d'ensemble soient améliorés, on constate une grande dispersion de cette valeur de la sensibilité dans un même lot de fabrication.

Il n'existe donc pas actuellement de système de fixation des lames piézo-électriques aux poteaux d'une embase permettant d'obtenir des sensibilités accélérométriques inférieures à $1 \times 10^{-9}/G$ avec une bonne reproductibilité de la valeur de la sensibilité aux accélérations.

La présente invention permet de résoudre le problème ainsi posé. Le résonateur selon l'invention est caractérisé en ce que lesdits moyens de fixation sont constitués par un ruban métallique prenant appui sur la partie intérieure de la zone périphérique, de manière à ce que ledit ruban soit disposé sensiblement dans le prolongement du poteau correspondant.

Selon une variante, le résonateur selon l'invention est caractérisé en ce que l'embase comporte également au moins un poteau de maintien relié au résonateur par l'intermédiaire d'un ruban métallique prenant appui sur la partie intérieure de la zone périphérique du résonateur, de manière à ce que ledit ruban soit disposé sensiblement dans le prolongement du poteau correspondant, ledit ruban étant disposé de manière à éviter tout contact électrique entre le poteau de maintien et les électrodes de la lame.

De préférence, la largeur des fentes dans lesquelles prennent appui les rubans métalliques est sensiblement égale à l'épaisseur du ruban de fixation utilisé.

On constate que les résonateurs réalisés selon l'invention permettent d'obtenir des sensibilités aux accélérations inférieures à $1 \times 10^{-9}/G$ avec un pourcentage de réussite très important. En effet, ainsi qu'on le verra d'après l'exemple comparatif cité plus loin, on peut en utilisant l'invention, non seulement améliorer la sensibilité aux accélérations du résonateur, mais on multiplie sensiblement par 3 le rendement de l'opération.

L'invention sera mieux comprise à l'aide des exemples de réalisation suivants, donnés à titre non limitatif, conjointement avec les figures qui représentent :

- la figure 1, une vue d'une lame piézo-électrique fixée sur une embase selon l'invention,

- la figure 2, une vue en coupe de la figure précédente au niveau d'une fixation.

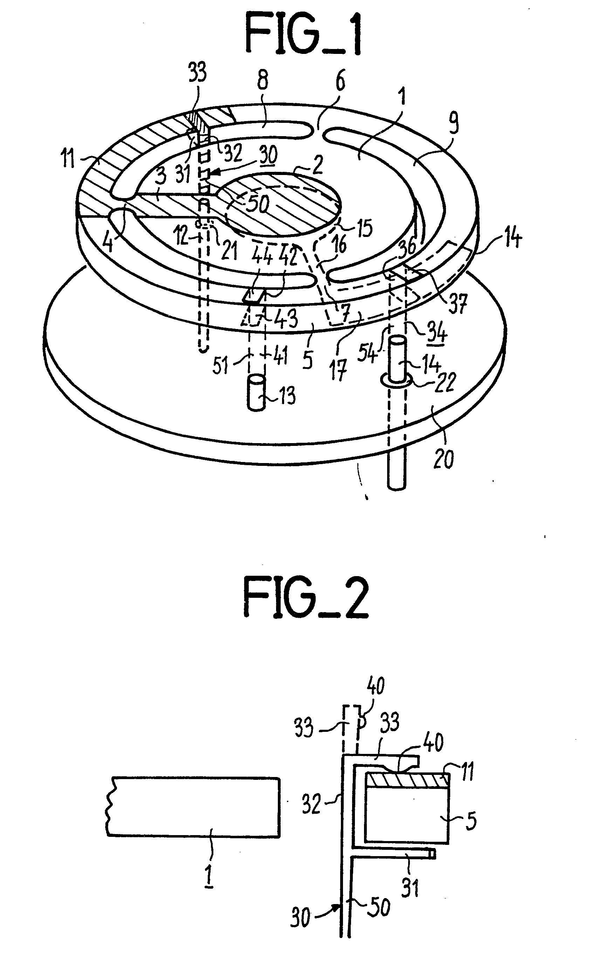

Sur la figure 1, est représentée une vue d'une lame piézo-électrique reliée aux poteaux de l'embase à l'aide de moyens de fixation selon l'invention. La lame piézo-électrique comporte une zone active centrale 1, entourée par une couronne périphérique 5, reliée à celle-ci par 3 ponts, dans l'exemple présent, 4, 6, 7. Ces ponts 4, 6, 7 délimitent des fentes 8, 9 et 10 séparant la zone centrale 1 de la couronne périphérique 5.

Chaque face de la zone centrale 1 est revêtue d'une électrode adhérente 2, 15 déposée de manière connue en soi. Chaque électrode 2, 15 se prolonge, au travers de l'un au moins des ponts respectivement 4 et 7 sur une partie 11, 17 de la couronne périphérique 5. Chaque électrode 2, 15 de la lame piézo-électrique est ainsi reliée à l'un des poteaux conducteurs 12, 14, traversant l'embase 20 à travers une perle de verre isolante 21, 22, par l'intermédiaire de moyens de fixation de conducteurs 30, 34. Ces moyens de fixation conducteurs 30, 34 sont respectivement constitués par une partie rectiligne conductrice sous forme d'un ruban plat 50, 54 soudé respectivement à l'extrémité du poteau 12, 14. Cette partie rectiligne 30, 34 (située dans le prolongement du poteau 12, 14 et donc sensiblement perpendiculaire à l'embase horizontale 20) se prolonge par une partie rectiligne plane sensiblement horizontale 31, 35 et une partie sensiblement verticale 32, 36, elle-même prolongée par une partie horizontale 33, 37. L'ensemble 31, 32, 33 et 35, 36, 37, vient pincer la couronne périphérique 5 de la lame piézo-électrique, la partie rectiligne 32, 36 étant située à proximité du bord intérieur, côté fente 8, 9, de ladite couronne périphérique 5. La partie rectiligne horizontale 33, 35 vient en contact électrique avec la partie 11, 17 prolongeant respectivement chaque électrode métallique 2, 15. Bien entendu, la présence de ces deux moyens de fixation est indispensable pour permettre le fonctionnement selon l'invention. Toutefois, il est possible de prévoir, de manière supplémentaire, d'autres moyens de fixation de structure tout à fait identique à ceux décrits précédemment mais n'ayant pas de fonction électrique de connexion. Ces moyens sont représentés dans le prolongement du poteau 13 solidaire de l'embase mais non isolé électriquement de celui-ci. Ces moyens 41 sont constitués par une partie plane sensiblement verticale 51 solidaire de l'extrémité du poteau 13 se prolongeant comme précédemment par une pince en forme de U comportant trois bras 43, 42 et 44, le bras 43 étant disposé sous la couronne périphérique 5, le bras 42 dans le prolongement de 51 et sur la face interne de la couronne périphérique 5, dans la fente 10, et le bras 44 disposé sensiblement horizontalement, au-dessus de ladite couronne périphérique 5.

La figure 2 représente une vue en coupe du résonateur de la figure 1, au niveau des moyens de fixation 30. Sur cette figure, les mêmes éléments que ceux de la figure précédente portent les mêmes références. On remarquera, en particulier, que, de préférence, la partie inférieure du bras supérieur 33 de la pince en forme de U 31, 32, 33 comporte un bossage 40 de manière à améliorer le contact électrique avec la métallisation 11 qui prolonge l'électrode 2. On notera également que, afin de permettre une fixation aisée de la lame piézo-électrique, selon le procédé de l'invention, on maintiendra tout d'abord la partie supérieure 33 de la pince dans le prolongement de la partie de la base 32 du U, on introduira alors la lame de quartz de manière à ce que les moyens de fixation 30 se glissent dans les fentes correspondantes de ladite lame, puis on rabattra à l'aide d'un outil approprié, la partie 33 sur la partie métallisée 11, en prolongement de l'électrode 2, ce rabattement s'effectuant sensiblement selon un angle de 90°.

D'une manière générale, on pourra utiliser comme moyens de fixation 30 et 34 des rubans plats de nickel. Ces rubans, reliant la lame du résonateur aux poteaux de traversée isolants 12, 14, doivent être maintenus le plus perpendiculairement possible par rapport au plan de l'embase 20 (ou au plan inférieur, côté métallisation de l'électrode 15 du résonateur), tout en restant droits, c'est-à-dire sensiblement selon la direction verticale sur la figure entre la lame et l'embase. D'une manière générale également, ces moyens de fixation sont applicables à tous les résonateurs munis de fentes, c'est-à-dire présentant une pluralité de ponts et de fentes entre la lame vibrante et un anneau périphérique. De préférence, l'invention s'appliquera à des lames comportant des fentes dont celles correspondant au passage des rubans métalliques sont de petites dimensions, laissant simplement passer lesdits rubans de nickel.

La fixation de la lame sur le support en forme de ruban peut se faire par un ciment conducteur connu en soi, le support pouvant présenter alors deux parties, l'une, pliée telle que par exemple 31 sur la figure 2, l'autre 33 étant rabattue après avoir positionné la lame sur la partie telle que 31.

Exemple de réalisation

On réalise des résonateurs piézo-électriques tels que décrits dans l'exemple 3 de la demande française 83/15 653 citée plus haut, c'est-à-dire des résonateurs plan convexe de 10 MHZ de type SCP 3 comportant 4 ponts disposés à ± 15° par rapport à l'axe ZZ'. Le diamètre extérieur de la lame est de 15 mm. Le diamètre de la partie active est de 10 mm avec un diamètre de métallisation d'électrodes de 6 mm. La couronne périphérique a une largeur de 1,5 mm tandis que chaque fente a une largeur de 1 mm.

On fixe une lame de quartz telle que définie ci-dessus sur une embase standard dont les poteaux sont disposés sur un cercle. Ces poteaux sont de diamètre 1 mm environ. Ils sont tangents à un cercle de diamètre 10 mm à l'extérieur de celui-ci. Dans le premier cas, on fixe la lame de quartz de la manière habituelle, c'est-à-dire à l'aide de rubans plats formant ressorts, fixés sur l'extérieur des poteaux (cercle de diamètre 12 mm) d'une part et sur l'extérieur de la couronne périphérique d'autre part (cercle de diamètre 15 mm). Les ressorts comportent donc une partie inclinée, d'environ 15° par rapport à l'axe des poteaux.

Dans le second cas, selon l'invention, on fixe le ruban métallique tel que décrit ci-avant sur la face intérieure de la couronne périphérique d'une part (de préférence dans les fentes les moins longues, sensiblement au milieu) et sur la face intérieure des poteaux (cercle de diamètre 10 mm) d'autre part. Les rubans métalliques selon l'invention sont donc placés sensiblement dans le prolongement du poteau correspondant.

On constate, que pour un lot de résonateurs fabriqués selon le premier cas, on n'obtient que 30 % de résonateurs tels que la sensibilité aux accélérations est inférieure à 3 x 10⁻¹⁰/G, tandis que pour un lot de résonateurs utilisant les moyens de fixation selon le deuxième cas, on constate que 80 % des résonateurs permettent d'obtenir une sensibilité aux accélérations inférieure à 3 x 10⁻¹⁰/G.

## Revendications

1. Résonateur piézo-électrique comportant une embase (20) traversée par deux poteaux conducteurs (12, 14) isolés de celle-ci et une lame piézo-électrique comportant une zone active centrale (1) entourée par une couronne périphérique (5) reliée à la zone centrale (1) par au moins deux ponts (4, 6, 7) délimitant des fentes (8, 9, 10) séparant la zone centrale (1) de la couronne périphérique (5), chaque face de la zone centrale (1) étant revêtue d'une électrode adhérente (2, 15) se prolongeant au travers de l'un au moins des ponts (4, 7) sur une partie (11, 17) de la couronne périphérique (5), chaque électrode (2, 15) de la lame étant reliée à l'un des poteaux conducteurs (12, 14) par l'intermédiaire de moyens de fixation conducteurs (30, 34), caractérisé en ce que lesdits moyens de fixation conducteurs (30, 34) sont constitués par un ruban métallique (30, 34) prenant appui sur la partie intérieure de la zone périphérique de manière à ce que ledit ruban soit disposé sensiblement dans le prolongement du poteau correspondant (12, 14).

2. Résonateur selon la revendication 1, caractérisé en ce que l'embase comporte également au moins un poteau de maintien (13) relié au résonateur par l'intermédiaire d'un ruban métallique (41) prenant appui sur la partie intérieure de la zone périphérique (5), de manière à ce que ledit ruban (41) soit disposé sensiblement dans le prolongement du poteau correspondant (13), ledit ruban étant fixé à ladite couronne (5) de manière à éviter tout contact électrique entre le poteau de maintien (13) et les électrodes de la lame (2, 15).

3. Résonateur selon l'une des revendications 1 ou 2, caractérisé en ce que la largeur des fentes (8, 9, 10) dans lesquelles prennent appui les rubans métalliques est sensiblement égale à l'épaisseur du ruban utilisé (30, 34, 41).

4. Résonateur selon l'une des revendications 1 à 3, caractérisé en ce que le ruban (30) comporte un premier bras (31) parallèle à l'embase disposé sous la couronne périphérique (5) et un second bras (33) disposé sur la couronne périphérique, parallèlement à l'embase.

5. Résonateur selon la revendication 4, caractérisé en ce que le second bras (33) est l'extrémité repliée du ruban (30).

## Claims

1. Piezoelectric resonator comprising a base (20) crossed by two conductive rods (12, 14) insulated from the latter and a piezoelectric lamella comprising an active central zone (1) surrounded by a peripheral crown (5) connected to the central zone (1) by at least two bridges (4, 6, 7) defining slots (8, 9, 10) separating the central zone (1) from the peripheral crown (5), each face of the central zone (1) being covered with an adhering electrode (2, 1) extended through at least one of the bridges (4, 7) to a portion (11, 17) of the peripheral crown (5), each electrode (2, 15) of the lamella being connected to one of the conductive rods (12, 14) through conductive fixing means (30, 34), characterized in that said conductive fixing means (30, 34) are made up by a metallic strip (30, 34) bearing on the inner portion of the peripheral zone so that said strip is substantially disposed in the extension of the corresponding rod (12, 14).

2. Resonator according to claim 1, characterized in that the base further comprises at least one holding rod (13) connected to the resonator through a metallic strip (41) bearing on the inner portion of the peripheral zone (5) in such a manner that said strip (41) is substantially disposed in the extension of the corresponding rod (13), said strip being fixed to said crown (5) in a manner to avoid any electric contact between the holding rod (13) and the electrodes of the lamella (2, 15).

3. Resonator according to claim 1 or 2, characterized in that the width of the slots (8, 9, 10) wherein the metallic strips are supported is substantially equal to the thickness of the strip (30, 34, 41) which is used.

4. Resonator according to any of claims 1 to 3, characterized in that the strip (30) comprises a first arm (31) which is parallel to the base and disposed beneath the peripheral crown (5) and a second arm (33) disposed above the peripheral crown in parallel to the base.

5. Resonator according to claim 4, characterized in that the second arm (33) is the folded end of the strip (30).

## Patentansprüche

1. Piezoelektrischer Resonator mit einem Sockel (20), der von zwei von diesem isolierten Leiterstäben (12, 14) durchquert wird, und einer piezoelektrischen Lamelle, die eine aktive zentrale Zone (1) aufweist, welche von einem Umfangskranz (5) umgeben ist, der mit der zentralen Zone (1) über wenigstens zwei Brücken (4, 6, 7) verbunden ist, die Schlitze (8, 9, 10) begrenzen, welche die zentrale Zone (1) von dem Umfangskranz (5) trennen, wobei jede Fläche der zentralen Zone (1) mit einer anhaftenden Elektrode (2, 15) bedeckt ist, die über wenigstens eine der Brücken (4, 7) zu einem Teil (11, 17) des Umfangskranzes (5) verlängert ist, wobei jede Elektrode (2, 15) der Lamelle mit einem der Leiterstäbe (12, 14) über leitfähige Befestigungsmittel (30, 34) verbunden ist, dadurch gekennzeichnet, daß die leitfähigen Befestigungsmittel (30, 34) durch einen Metallstreifen (30, 34) gebildet sind, welcher sich auf dem inneren Teil der Umfangszone in solcher Weise abstützt, daß der genannte Streifen im wesentlichen in der Verlängerung des entsprechenden Leiterstabes (12, 14) liegt.

2. Resonator nach Anspruch 1, dadurch gekennzeichnet, daß der Sockel ferner wenigstens einen Haltestab (13) umfaßt, der mit dem Resonator über einen Metallstreifen (41) verbunden ist, welcher sich an dem unteren Teil der Umfangszone (5) abstützt, dergestalt, daß der genannte Streifen (41) im wesentlichen in der Verlängerung des entsprechenden Stabes (13) liegt, wobei der genannte Streifen an dem genannten Kranz (5) in solcher Weise befestigt ist, daß jeder elektrische Kontakt zwischen dem Haltestab (13) und den Elektroden der Lamelle (2, 15) vermieden wird.

3. Resonator nach Anspruch 1 oder 2, dadurch gekennzeichnet, daß die Breite der Schlitze (8, 9, 10), worin sich die metallischen Streifen abstützen, im wesentlichen gleich der Dicke des verwendeten Streifens (30, 34, 41) ist.

4. Resonator nach einem der Ansprüche 1 bis 3, dadurch gekennzeichnet, daß der Streifen (30) einen ersten, zum Sockel parallelen Arm (31) umfaßt, der unter dem Umfangskranz (5) liegt, und einen zweiten Arm (33) umfaßt, der auf dem Umfangskranz parallel zum Sockel angeordnet ist.

5. Resonator nach Anspruch 4, dadurch gekennzeichnet, daß der zweite Arm (33) das umgefaltete Ende des Streifens (30) ist.

# FIG_1

# FIG_2